Europäisches Patentamt

European Patent Office

Office européen des brevets

(19)

(11) **EP 1 365 510 A1**

(12) **EUROPÄISCHE PATENTANMELDUNG**

(43) Veröffentlichungstag:
**26.11.2003   Patentblatt 2003/48**

(51) Int Cl.⁷: **H03K 3/037**, H03K 17/082

(21) Anmeldenummer: **03009627.5**

(22) Anmeldetag: **29.04.2003**

(84) Benannte Vertragsstaaten:
**AT BE BG CH CY CZ DE DK EE ES FI FR GB GR HU IE IT LI LU MC NL PT RO SE SI SK TR**
Benannte Erstreckungsstaaten:
**AL LT LV MK**

(30) Priorität: **24.05.2002  DE 10223169**

(71) Anmelder: **SIEMENS AKTIENGESELLSCHAFT**
**80333 München (DE)**

(72) Erfinder: **Adams, Jürgen**
**78052 Villingen-Schwenningen (DE)**

(54)   **Schaltungsanordnung zur Frequenzteilung**

(57)   Es ist eine Schaltungsanordnung zur Frequenzteilung (16) angegeben, welche zur Frequenzteilung ein Kippglied (3) mit Rückkopplung umfasst. An den Ausgang des Kippgliedes (3) ist ein Mittel zur Stromerfassung (7) angeschlossen. Dieses erfasst den Ausgangsstrom des Kippgliedes (3) und bewirkt bei Vorliegen eines Überlast- oder Fehlerfalles ein Rücksetzen des Kippgliedes (3). Sobald der Fehlerzustand entfällt, kann ohne Abkühlphase wieder ein Normalbetrieb aufgenommen werden. Damit kann eine thermische Überlastung einer Ausgangsstufe (6) mit Vorteil vermieden werden. Die Frequenzteilerschaltung ist bevorzugt zur Anwendung in Kraftfahrzeugen vorgesehen.

FIG 1

EP 1 365 510 A1

**Beschreibung**

Die vorliegende Erfindung betrifft eine Schaltungsanordnung zur Frequenzteilung.

Impulsteiler werden normalerweise eingesetzt, um einerseits ein Eingangssignal hoher Frequenz von einem Ausgangssignal zu entkoppeln und andererseits ein Ausgangssignal mit geringerer Frequenz bereitzustellen, mit dem Endgeräte entsprechend ihrer Spezifikationen angesteuert werden können. Derartige Frequenzteiler oder Impulsteiler werden beispielsweise in Kraftfahrzeugen verwendet, um die von einer Impulsquelle bereitgestellten Signale in Signale mit einer niedrigeren Frequenz umzusetzen, zu verstärken und derart aufbereitet weiteren Geräten zur Verfügung zu stellen. Als weitere Geräte kommen beispielsweise Radiogerät, Navigationshilfe, Tempomat, Bremsassistenten sowie Traktionskontrollsysteme in Frage. Die von der Impulsquelle bereitgestellten Impulse sind üblicherweise Wegimpulse, mit denen auf die aktuelle Fahrgeschwindigkeit bezogen auf den Untergrund rückgeschlossen werden kann.

Insbesondere bei Einsatz derartiger Impulsteilerschaltungen oder Frequenzteilerschaltungen in Kraftfahrzeugen kann es gewünscht sein, bei Vorliegen eines Fehlerzustandes das Ausgangssignal des Frequenzteilers zu unterdrücken beziehungsweise den Frequenzteiler und/oder nachgeschaltete Geräte vor den auftretenden hohen Strömen zu schützen. Ein derartiger Fehlerzustand kann beispielsweise ein Kurzschluss des Ausgangs des Frequenzteilers gegen Versorgungsspannung sein. Die Versorgungsspannung ist dabei die Bordnetz-Spannung im Kraftfahrzeug von 12 oder 24 Volt.

Zur Bereitstellung eines Kurzschluss-Schutzes gegen Versorgungsspannung könnte an den Ausgang des Frequenzteilers ein Schutzwiderstand angeschaltet sein, der in der Lage ist, die mit dem Kurzschluss-Fall verbundenen, hohen Kurzschlussströme aufzunehmen. Alternativ könnten auch temperaturabhängige Schutzwiderstände, sogenannte PTC(Positive Temperature Coefficient)-Widerstände, das sind Widerstände mit positiven Temperaturkoeffizienten, eingesetzt werden, so dass im Kurzschlussfall die aufgenommene Verlustleistung auf günstigere Werte begrenzt werden kann. Schließlich könnte durch den Einsatz von thermisch geschützten Schalttransistoren, wie sie beispielsweise unter dem Handelsnamen TEMPFET erhältlich sind, ein Schutz vor hohen Kurzschlussströmen erfolgen. Diese Lösung wäre jedoch zum einen platzintensiv und zum anderen sehr aufwendig.

Weiterhin ist es wünschenswert, dass der Signalausgang des Frequenzteilers als Open-Collector-Ausgang ausgebildet ist, um elektrische Pull-Up-Lasten ansteuern zu können.

Schließlich sollte in einem Normalbetrieb, bei aktivem Ausgang des Frequenzteilers, und bei Vorliegen eines logischen Low-Pegels am Ausgang des Frequenzteilers, die Restspannung, die am Ausgang verbleibt, kleiner als 0,8 Volt sein.

Erfindungsgemäß wird die Aufgabe gelöst durch eine Schaltungsanordnung zur Frequenzteilung, umfassend

- ein als Frequenzteiler ausgelegtes Kippglied mit einem Takteingang zum Zuführen eines Eingangssignals, mit einem Ausgang, an dem ein Signal mit geteilter Frequenz des Eingangssignals bereitgestellt ist, und mit einem Rücksetzeingang, und
- ein Mittel zur Stromerfassung, umfassend einen Vergleicher mit einem ersten Eingang, der mit dem Ausgang des Kippgliedes zur Erfassung eines vom Signal mit geteilter Frequenz abhängigen Ausgangsstroms gekoppelt ist, mit einem zweiten Eingang, der mit einer Referenzquelle gekoppelt ist, und mit einem Ausgang, der mit dem Rücksetzeingang des Kippgliedes gekoppelt ist und in Abhängigkeit von einem Vergleichsergebnis im Vergleicher den Rücksetzeingang ansteuert.

Das Kippglied wird an seinem Takteingang mit dem Eingangssignal angesteuert und stellt an seinem Ausgang ein Signal mit geteilter Frequenz des Eingangssignals, bevorzugt mit der halben Eingangssignalfrequenz, bereit. Das an den Ausgang des Kippgliedes angeschlossene Mittel zur Stromerfassung erfasst den vom Ausgangssignal mit der geteilten Signalfrequenz abhängigen Ausgangsstrom und vergleicht diesen Stromwert oder ein von diesem Stromwert abhängiges Signal mit einem von der Referenzquelle bereitgestellten Referenzsignal.

Übersteigt der Ausgangsstrom einen festlegbaren Schwellwert, der von der Referenzquelle eingestellt ist, so wird das Kippglied durch entsprechende Ansteuerung seines Rücksitzeingangs zurückgesetzt.

Man kann demnach einen Normalbetrieb und einen Fehlerbetrieb unterscheiden. Im Normalbetrieb arbeitet das Kippglied als Frequenzteiler. Hierfür kann bevorzugt ein invertierender Ausgang des Kippgliedes mit einem Dateneingang desselben in einer Rückkoppelung verbunden sein.

In einem Fehlerbetrieb, beispielsweise bei Vorliegen eines Kurzschlusses zwischen Ausgang und Versorgungspotential, fließt typischerweise ein unzulässig großer Ausgangsstrom, der von dem Signal mit geteilter Frequenz abhängig ist. Dieser Ausgangsstrom fließt demnach in Abhängigkeit von dem aktuellen, am Ausgang des Kippgliedes vorliegenden logischen Zustands. Der unzulässig hohe Ausgangsstrom wird mit dem Mittel zur Stromerfassung durch Vergleichen mit einem Stellwert detektiert und bei Vorliegen eines Fehlers wird das Kippglied zurückgesetzt.

Dieser Vorgang wiederholt sich so lange, wie ein Kurzschluss vorliegt. Sobald der Kurzschluss entfällt, ist die Schaltung unmittelbar und mit Vorteil ohne Erholzeit wieder betriebsbereit.

Da Schaltungsanordnungen zur Frequenzteilung ohnehin üblicherweise ein als Frequenzteiler ausgelegtes Kippglied umfassen, ist ausgehend von diesen Schaltungen das vorliegende Prinzip mit geringem Aufwand realisierbar. Ein zusätzlicher Vorteil ergibt sich durch die Rückkehrmöglichkeit in einen Normalbetrieb ohne eine Erholzeit, wie sie von den eingangs erwähnten thermischen Schutzeinrichtungen bekannt ist.

Gemäß einer bevorzugten Ausführungsform der Erfindung ist ein Ausgangstransistor vorgesehen, mit einem Steuereingang, der mit dem Ausgang des Kippgliedes gekoppelt ist und mit einer gesteuerten Strecke, mit einem Anschluss, der an den ersten Eingang des Vergleichers zum Zuführen des Ausgangsstromes angeschlossen ist. Der weitere Anschluss der gesteuerten Strecke, der bevorzugt den Ausgang des Frequenzteilers bildet, ist bevorzugt als Open-Collector-Ausgang bzw. als Open-Drain-Ausgang ausgebildet. Somit können mit Vorteil elektrische Lasten angesteuert werden, die sich durch einen gegen Versorgungspotential geschalteten Pull-Ip-Widerstand auszeichnen.

Zur Stromerfassung des Ausgangsstromes, der vom Signal mit geteilter Frequenz abhängt, ist bevorzugt ein Gegenkopplungswiderstand vorgesehen. Dieser ist zwischen den Anschluss der gesteuerten Strecke des Ausgangstransistors und einen Bezugspotentialanschluss geschaltet und stellt eine dem Ausgangsstrom zugeordnete Spannung zur Verfügung. Diese kann am Verbindungsknoten zwischen der gesteuerten Strecke des Ausgangstransistors und dem Gegenkopplungswiderstand abgegriffen und dem Vergleicher an seinem ersten Eingangsanschluss zugeführt werden. Diese Stromgegenkopplung bewirkt mit Vorteil eine Strombegrenzung am Ausgangstransistor, so dass bis zu dessen Abschalten mittels der Rücksetzung des Kippgliedes eine Überlastung des Ausgangstransistors vermieden wird. Auf Grund der sehr kurzen Zeitdauer des Stromflusses ist eine thermische Überlastung des Ausgangstransistors besonders wirksam vermieden.

Gemäß einer weiteren, bevorzugten Weiterbildung der vorliegenden Erfindung ist ein Dämpfungskondensator vorgesehen, der parallel zum Gegenkopplungswiderstand geschaltet ist und Spannungsspitzen am Gegenkopplungswiderstand verhindert, welche beispielsweise durch Leitungskapazitäten oder optionale Entstörkondensatoren bei normalen Umschaltvorgängen verursacht werden. Solche Spannungsspitzen könnten, ohne dass ein tatsächlicher Fehlerzustand vorliegt, zu einem unerwünschten Rücksetzen des Kippgliedes führen und werden mit dem Dämpfungskondensator zuverlässig von tatsächlichen Fehlerzuständen unterscheidbar gemacht.

Bevorzugt ist zur Vermeidung unerwünschter, leitungsgebundener oder eingestrahlter hochfrequenter Störanteile ein Entstörkondensator vorgesehen, welcher zwischen dem zweiten Anschluss der gesteuerten Strecke des Ausgangstransistors und einem Bezugspotentialanschluss geschaltet ist.

Weitere Einzelheiten und bevorzugte Weiterbildungen der Erfindung sind Gegenstand der Unteransprüche.

Die Erfindung wird nachfolgend an mehreren Ausführungsbeispielen anhand der Zeichnungen näher erläutert.

Es zeigen:

Figur 1     ein erstes Ausführungsbeispiel der vorliegenden Frequenzteilerschaltung anhand eines Schaltplanes,

Figur 2     ein Ausführungsbeispiel einer an den Frequenzteiler von Figur 1 anschließbaren elektrischen Last,

Figur 3     ein zweites Ausführungsbeispiel einer erfindungsgemäßen Frequenzteilerschaltung anhand eines Schaltplanes,

Figur 4     ein drittes Ausführungsbeispiel einer Frequenzteilerschaltung gemäß vorliegendem Prinzip anhand eines Schaltplanes, und

Figur 5     ein Anwendungsbeispiel der Frequenzteilerschaltungen von Figuren 1, 2 und 4 in einem Kraftfahrzeug anhand eines vereinfachten Blockschaltbildes.

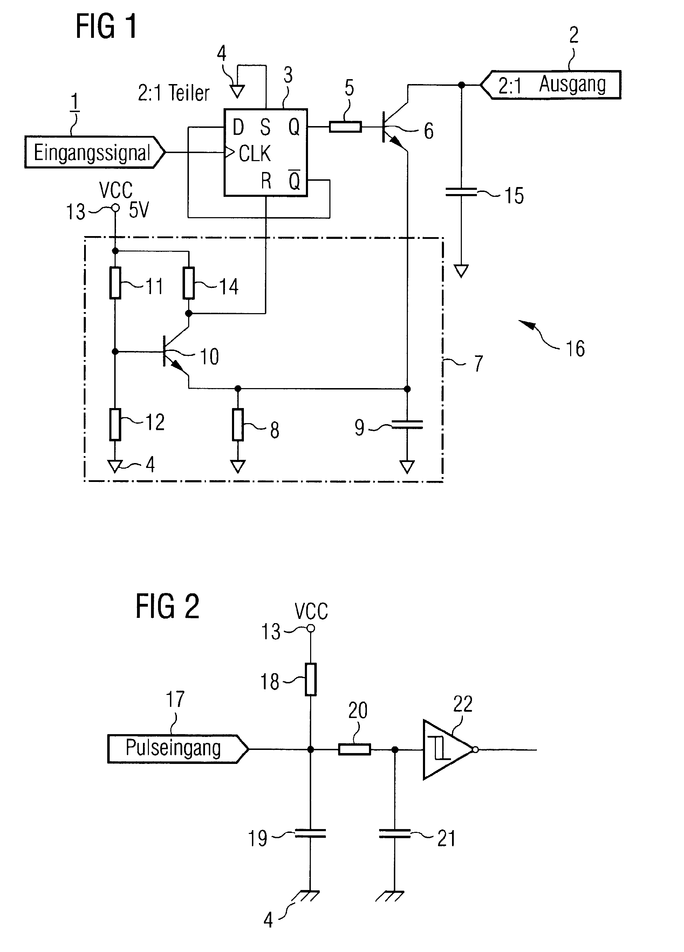

Figur 1 zeigt eine Schaltungsanordnung zur Frequenzteilung. An einem Eingang 1 der Frequenzteilerschaltung ist ein Eingangssignal mit einer zu teilenden Frequenz zuführbar, und am Ausgang 2 der Frequenzteilerschaltung wird ein Signal mit geteilter Frequenz des Eingangssignals bereitgestellt. Die Schaltungsanordnung zur Frequenzteilung umfasst ein als Frequenzteiler ausgelegtes Kippglied 3, welches als Flip-Flop ausgebildet ist. Dieses umfasst einen Dateneingang D, einen Takteingang CLK, einen Ausgang Q, einen invertierenden Ausgang Q', einen Setzeingang S sowie einen Rücksitzeingang R. Der Setzeingang S ist mit einem Bezugspotentialanschluss 4 verbunden. Der Takteingang CLK des Flip-Flops 3 ist mit dem Eingang 1 des Frequenzteilers verbunden. Damit das Flip-Flop 3 als 2:1-Frequenzteiler arbeitet, ist eine Rückkopplung durch Verbinden des invertierenden Ausgangs Q' mit dem Dateneingang D vorgesehen. Der Ausgang Q des Flip-Flops 3 ist über einen Basis-Widerstand 5 mit einem in bipolarer Schaltungstechnik ausgebildeten NPN-Ausgangstransistor 6 an dessen Basisanschluss verbunden. Der Kollektoranschluss des Ausgangstransistors 6 ist mit dem Ausgang 2 der Frequenzteilerschaltung verbunden. Dieser Ausgang ist als Open-Collector-Ausgang ausgelegt. Der Emitteranschluss ist an ein Mittel zur Stromerfassung 7 angeschlossen, welches den Ausgangsstrom am Ausgang 2 und durch den Transistor 6 erfasst und in Abhängigkeit von diesem Ausgangsstrom das Flip-Flop 3 ansteuert. Hierfür ist das Mittel zur Stromerfassung 7 mit dem Rücksetzeingang R des Flip-Flops 3 verbunden.

Das Mittel zur Stromerfassung 7 umfasst einen Gegenkopplungswiderstand 8, der den Emitteranschluss des Ausgangstransistors 6 mit Bezugspotentialanschluss 4 verbindet. Parallel zum Gegenkopplungswiderstand 8 ist ein Dämpfungskondensator 9 geschaltet. Ein weiterer Transistor 10, der als Vergleicher arbeitet, ist mit seinem Emitteranschluss an den Emitteranschluss des Ausgangstransistors 6 angeschlossen. Der Emitteranschluss des Transistors 10 bildet somit einen ersten Eingang eines Vergleichers. Den zweiten Eingangsanschluss des Vergleichers bildet der Basisanschluss des Transistors 10, der über einen Spannungsteiler 11, 12 mit einem Versorgungspotentialanschluss 13 verbunden ist. Der Spannungsteiler umfasst zwei Widerstände 11, 12, welche zwischen Versorgungspotentialanschluss 13 und Bezugspotentialanschluss 4 geschaltet sind. Weiterhin ist zur Bildung des Vergleichers ein Widerstand 14 vorgesehen, der den Versorgungspotentialanschluss 13 mit dem Kollektoranschluss des Transistors 10 verbindet. Der Kollektoranschluss des Transistors 10, welcher den Ausgang des Vergleichers repräsentiert, ist mit dem Rücksitzeingang des Flip-Flops 3 verbunden. Weiterhin ist zwischen dem Ausgang 2 des Frequenzteilers und Bezugspotentialanschluss 4 ein Entstörkondensator 15 zum Ausfiltern hochfrequenter Störanteile geschaltet.

Die Frequenzteilerschaltung gemäß Figur 1 ist mit Bezugszeichen 16 versehen.

Das D-Flip-Flop 3 hat die Eigenschaft, dass der Ausgang Q in den Low-Zustand versetzbar ist durch Anlegen eines High-Signals an den Reseteingang R.

Zur Erläuterung der Funktionsweise der Schaltung sollen im folgenden zwei Betriebsarten getrennt betrachtet werden, nämlich ein Normalbetrieb und ein Kurzschlussbetrieb. Im Normalbetrieb wird am Takteingang CLK des Flip-Flops 3 ein Eingangssignal zugeführt, welches mit jedem Takt den Ausgang Q zwischen einem logischen Low- und einem logischen High-Zustand hin- und herschaltet, so dass eine 2:1-Frequenzteilung erfolgt. In Abhängigkeit vom logischen Zustand am Ausgang Q wird der Ausgangstransistor 6 ein- und ausgeschaltet. Im eingeschalteten Zustand fließt ein Strom vom Ausgang 2, beispielsweise durch einen später anhand von Figur 2 erläuterten Pull-up-Widerstand 18 in einer elektrischen Last, durch den Ausgangstransistor 6 und den Gegenkopplungswiderstand 8 nach Masse. Über den Widerstand 8 fällt eine geringe Spannung ab, die jedoch nicht ausreicht, den Leitzustand des Transistors 10 zu verändern.

Im Kurzschlussbetrieb gelte die Annahme, dass der Kollektoranschluss des Ausgangstransistors 6 mit der Betriebsspannung VCC der Frequenzteilerschaltung verbunden sei. Wenn in Abhängigkeit von einem Geber-Takt am Takteingang CLK der Ausgang Q des Flip-Flops 3 in einen High-Zustand übergeht, so wird der Transistor 6 eingeschaltet. Da auf Grund des Fehlerzustands am Ausgang 2 Versorgungspotential anliegt, fließt ein großer Strom durch Ausgangstransistor 6 und durch den Gegenkopplungswiderstand 8. Dieser verhältnismäßig große Stromfluss bewirkt, dass sich auf Grund des Spannungsabfalls über dem Widerstand 8 eine Gegenspannung am Emitteranschluss des Ausgangstransistors 6 einstellt. Da in der Folge das am Basisanschluss des Ausgangstransistors 6 anliegende Signal bezogen auf seinen Emitteranschluss verhältnismäßig klein wird, nimmt die Leitfähigkeit des Ausgangstransistors 6 ab. Mit der über den Gegenkopplungswiderstand 8 abfallenden Spannung wird zugleich der Emitteranschluss des Transistors 10 potentialmäßig so angehoben, dass die Basis-Emitter-Spannung gegen null Volt geht oder negativ wird. Somit sperrt Transistor 10. Dies wiederum bewirkt, dass über den Widerstand 14 ein High-Signal an dem Rücksetz-Eingang R des Flip-Flops 3 anliegt. Dieses Rücksetz-Signal setzt unmittelbar den Ausgang Q des Flip-Flops 3 zurück. Somit geht der Transistor 6 in einen Sperrzustand über. Das fehlerbedingte Ausgangssignal am Ausgang 2 kann demnach nur für eine so kurze Zeit einen Stromfluss bereitstellen, dass keine thermischen Schädigungen durch den Kurzschlussfall auftreten können. Mit dem nächsten Taktzyklus am Eingang 1 der Frequenzteilerschaltung beziehungsweise mit dem nächsten Auftreten eines High-Pegels im Eingangssignal CLK wiederholt sich der beschriebene Vorgang so lange, wie der Kurzschluss gegen Versorgungspotential vorliegt. Sobald der Kurzschluss entfällt, ist die Frequenzteilerschaltung unmittelbar und mit Vorteil ohne Erholzeit wieder beriebsbereit. Im Gegensatz zu thermischen Schutzmechanismen ist demnach keine Abkühl-Phase erforderlich.

Für einen Nenn-Laststrom am Ausgang 2 von ca. 20 mA eignet sich vorliegend für den Gegenkopplungswiderstand 8 ein Widerstandswert von 22 Ohm. Allgemein sollte der Gegenkopplungswiderstand so ausgelegt sein, dass durch eine Strom-Gegenkopplung, welche eine Anhebung des Potentials am Emitter des Transistors 6 bewirkt, eine Strombegrenzung in diesem Transistor 6 eintritt, so dass in der kurzen Zeitspanne bis zur Abschaltung des Transistors durch Rücksetzen des Flip-Flops 3 keine Stromüberlastung eintritt.

In Abhängigkeit von der vom Spannungsteiler 11, 12 bereitgestellten Referenzspannung für den Vergleicher 10, 14 kann die Schwelle für den Übergang des Reset-Signals vom Low- in den High-Zustand, welches dem Flip-Flop 3 an dessen Rücksetzeingang R zugeführt wird, nährungsweise bestimmt werden gemäß der Vorschrift

$$I_{Schwelle} = \left( V_{cc} \cdot \frac{R_{12}}{R_{11} + R_{12}} \right) - U_{BE10} : R_8$$

Dabei repräsentiert der Strom $I_{Schwelle}$ den Ausgangsstrom, so dass gerade kein Kurzschluss erkannt wird. Die Versorgungsspannung $V_{CC}$ liegt typischerweise im Bereich von 5 Volt, während die Basis-Emitterspannung $U_{BE10}$ des Transistors 10 bei ca. 0,6 Volt liegt. $R_8$, $R_{11}$, $R_{12}$ repräsentieren die Widerstandswerte der jeweiligen Widerstände 8, 11, 12.

Bei Verwendung eines bipolaren NPN-Transistors 10 wird mit dem Widerstandsteiler 11, 12 diejenige Spannung eingestellt, die abzüglich der Basis-Emitter-Spannung des Transistors 10 über dem Gegenkopplungswiderstand 8 abfallen muss, um den Transistor zu sperren und damit das Reset-Signal zu erzeugen. Für einen Grenzstrom $I_{Schwelle}$ ±25 mA können beispielsweise folgende Widerstandswerte angegeben werden:

$R_{11}$ = 10 kOhm,
$R_{12}$ = 3,3 kOhm,
$R_8$ = 22 Ohm,
$V_{CC}$ = 5 Volt.

Die vorliegende Schaltung verbindet somit eine 2:1 Frequenzteilung mit einer Schutzschaltung gegen Kurzschlüsse nach Versorgungsspannung und vermeidet dabei die Nachteile einer thermischen Schutzvorrichtung. Das beschriebene Prinzip ist mit geringem Aufwand realisierbar und insbesondere zum Einsatz in Kraftfahrzeugen geeignet.

Figur 2 zeigt beispielhaft eine elektrische Last, die zum Anschluss an den Open-Collector-Ausgang 2 der Frequenzteilerschaltung 16 von Figur 1 ausgelegt ist. Hierfür umfaßt die Schaltung einen Signaleingang 17, der über eine elektrisch leitende Verbindung an den Ausgang 2 der Teilerschaltung 16 anschließbar ist. Der Eingang 17 ist über einen Pull-Up-Widerstand 18 mit Versorgungspotentialanschluss 13 verbunden. Somit kann die elektrische Last problemlos an den Open-Collector-Ausgang 2 angeschlossen werden. Zur Signalaufbereitung umfaßt die elektrische Last weiterhin einen Kondensator 19, der zwischen Eingang 17 und Bezugspotentialanschluss 4 geschaltet ist, sowie ein nachgeschaltetes RC-Glied umfassend einen Serienwiderstand 20 und einen gegen Masse geschalteten Kondensator 21. Ausgangsseitig an das RC-Glied 20, 21 ist zur weiteren Signalaufbereitung ein Komparator 22 mit Schalthysterese angeschlossen.

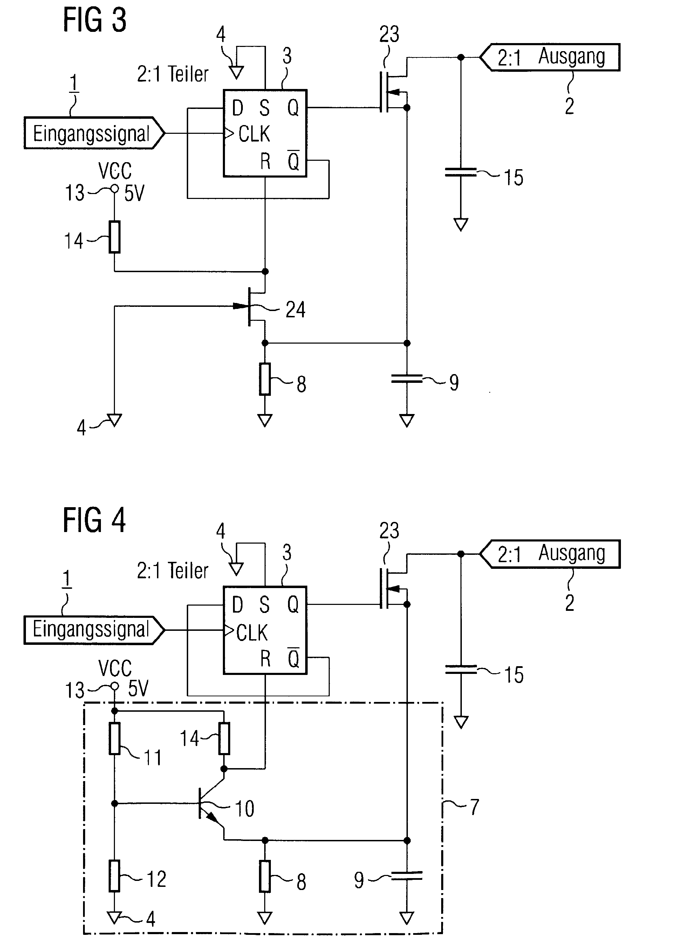

Figur 3 zeigt eine alternative Ausführungsform der Frequenzteilerschaltung von Figur 1, welche an Stelle der Realisierung in bipolarer Schaltungstechnik in MOS(Metal Oxide Semiconductor)-Schaltungstechnik aufgebaut ist. Da die Schaltung von Figur 3 derjenigen von Figur 1 in Aufbau und vorteilhafter Funktionsweise weitgehend entspricht, soll sie insoweit an dieser Stelle nicht noch einmal beschrieben werden. Anstelle des NPN-Ausgangstransistors 6 mit vorgeschaltetem Basiswiderstand 5 ist vorliegend ein MOS-Transistor 23 als Ausgangstransistor vorgesehen, dessen Gate-Elektrode unmittelbar den Ausgang Q des Flip-Flops 3 angeschlossen ist, dessen Drain-Anschluss mit dem Ausgang 2 verbunden ist und dessen Source-Anschluss über Gegenkopplungswiderstand 8 und parallel dazu über Dämpfungskondensator 9 mit Bezugspotentialanschluss 4 verbunden ist. Weiterhin ist anstelle des NPN-Transistors 10 und des Spannungsteilers 11, 12 ein weiterer MOS-Transistor 24 vorgesehen, der als Vergleicher arbeitet. Dieser ist mit seinem Source-Anschluss mit dem Source-Anschluss des Transistors 23, mit seinem Drain-Anschluss an den Rücksetzeingang R des Flip-Flops 3 sowie über den Widerstand 14 mit Versorgungspotentialanschluss 13 verbunden. Der Gate-Anschluss des weiteren Transistors 24 ist unmittelbar an Bezugspotentialanschluss 4 angeschlossen.

Der bei Figur 3 vorgesehene Open-Drain-Ausgang entspricht in seiner Funktion dem Open-Collector-Ausgang 2 von Figur 1. Der Ausgangstransistor 23 ist als n-Kanal-Feldeffekttransistor vom Verarmungstyp ausgebildet. Der Vergleicher ist als n-Kanal-Transistor vom Sperrschicht-Typ 24 ausgebildet.

Bei der Schaltung von Figur 3 wird der Übergang des Reset-Signals, welches am Drain-Anschluss des Transistors 24 bereitgestellt wird, bestimmt durch die eingeprägte Sperr-Schwellspannung $U_{GS}$ des Feldeffekttransistors 24. Diese führt zur Verarmung von Ladungsträgern im Leitkanal und überführt den Transistor 24 damit in den Sperrzustand. Mit dem Anstieg der Spannung über dem Gegenkopplungswiderstand 8 wird die Gate-Spannung relativ betrachtet negativ. Bei herkömmlichen Transistoren erfolgt dies typischerweise bei einer Spannung von ca. 0,7 Volt.

Figur 4 zeigt ein drittes Ausführungsbeispiel einer Frequenzteilerschaltung, ausgehend von der Frequenzteilerschaltung von Figur 1. Die vorliegende Frequenzteilerschaltung entspricht in Aufbau und Funktionsweise weitgehend der Frequenzteilerschaltung von Figur 1 und wird insoweit an dieser Stelle nicht noch einmal beschrieben. Das Mittel zur Stromerfassung 7 mit dem bipolar ausgeführten Vergleichertransistor 10 entspricht in Aufbau und Funktion vollständig dem Mittel zur Stromerfassung 7 von Figur 1. Lediglich der Ausgangstransistor 6 samt Basiswiderstand 5 von Figur 1 ist, wie bei Figur 3, vorliegend durch eine MOS-Ausgangsstufe 23 ersetzt. Diese MOS-Schaltungsvariante des Frequenzteilers entspricht damit einer Kombination der Ausführungsbeispiele von Figur 1 und 3.

Den gezeigten Frequenzteilerschaltungen gemäß Figuren 1, 3 und 4 und der elektrischen Last gemäß Figur 2 ist es gemeinsam, dass eventuell vorhandene zusätzliche Bauteile, die für die Funktion des Kurzschluss-Schutzes nicht von unmittelbarer Bedeutung sind, wie zusätzliche Störschutzmaßnahmen und Netzteile, nicht eingezeichnet sind.

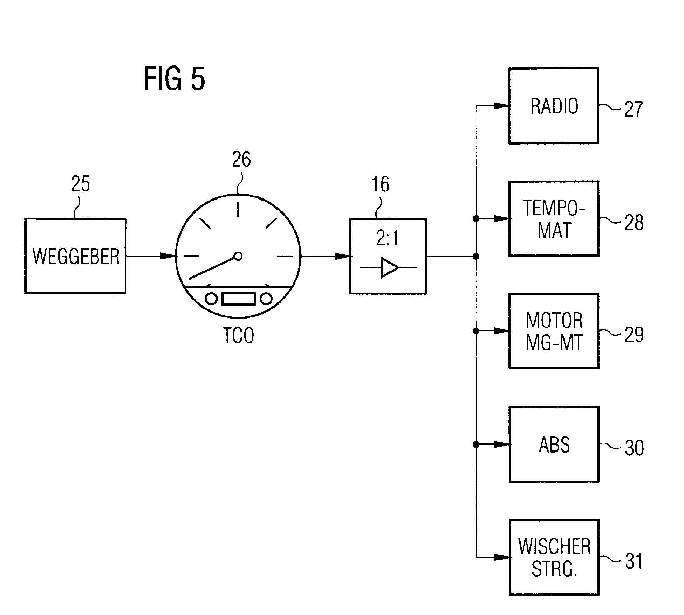

Figur 5 schließlich zeigt anhand eines vereinfachten Blockschaltbildes einen möglichen Anwendungsfall des beschriebenen Frequenzteilers mit Kurzschluss-Schutz in einem Fahrzeug. Demgemäß ist als Signalquelle ein Weggeber 25 vorgesehen, der Wegimpulse bereitstellt. Die Pulszahl pro Zeiteinheit gibt dabei eine Information über die zurückgelegte Wegstrecke wieder. Der Weggeber kann auch als Fahrtschreiber ausgebildet sein. An den Ausgang des Weggebers 25 ist ein Tachograph 26 angeschlossen, wie er üblicherweise in Kraftfahrzeugen zur optischen Anzeige der aktuellen Geschwindigkeit des Fahrzeugs verwendet wird. Der Tachograph 26 kann weitere Funktionen wie beispielsweise Durchschnittsgeschwindigkeit, zurückgelegte Wegstrecke, Gesamtkilometerstrecke et cetera aufweisen. An den Ausgang des Weggebers 25 oder an den Ausgang des Tachographen 26 ist ein Frequenzteiler 16, wie beispielhaft in Figuren 1, 3 und 4 angegeben, angeschlossen, der eine Frequenzteilung durch zwei, sowie eine Signalaufbereitung durchführt und einen Kurzschluss-Schutz bereitstellt. Der Frequenzteiler 16 steuert weitere Komponenten an, welche eine niedrigere Eingangsfrequenz als vom Weggeber 25 bereitgestellt benötigen, wie beispielsweise Radiogeräte, Tempomaten, Motormanagement des Kraftfahrzeuges, Steuerung der Scheibenwischer sowie Traktionskontrollsysteme, insbesondere Antiblockiersysteme, Antischlupfregelungen, elektronische Stabilitätshilfen oder ähnliche. Diese sind in der Blockschaltbilddarstellung mit den Bezugszeichen 27 bis 31 versehen.

## Patentansprüche

1. Schaltungsanordnung zur Frequenzteilung, umfassend

   - ein als Frequenzteiler ausgelegtes Kippglied (3) mit einem Takteingang (CLK) zum Zuführen eines Eingangssignals, mit einem Ausgang (Q), an dem ein Signal mit geteilter Frequenz des Eingangssignals bereitgestellt ist, und mit einem Rücksetzeingang (R), und
   - ein Mittel zur Stromerfassung (7), umfassend einen Vergleicher (10, 14) mit einem ersten Eingang, der mit dem Ausgang (Q) des Kippgliedes (3) zur Erfassung eines vom Signal mit geteilter Frequenz abhängigen Ausgangsstroms gekoppelt ist, mit einem zweiten Eingang, der mit einer Referenzquelle (11, 12) gekoppelt ist, und mit einem Ausgang, der mit dem Rücksetzeingang (R) des Kippgliedes (3) gekoppelt ist und in Abhängigkeit von einem Vergleichsergebnis den Rücksetzeingang (R) ansteuert.

2. Schaltungsanordnung nach Anspruch 1,
   **dadurch gekennzeichnet, dass**
   ein Ausgangstransistor (6) vorgesehen ist, mit einem Steuereingang, der an den Ausgang (Q) des Kippglieds (3) angeschlossen ist, und mit einer gesteuerten Strecke aufweisend einen Anschluss, der an den ersten Eingang des Vergleichers (10, 14) zum Zuführen des Ausgangsstroms angeschlossen ist.

3. Schaltungsanordnung nach Anspruch 2,
   **dadurch gekennzeichnet, dass**
   das Mittel zur Stromerfassung (7) einen Gegenkopplungswiderstand (8) umfasst, der zwischen den Anschluss der gesteuerten Strecke des Ausgangstransistors (6) und einen Bezugspotentialanschluss (4) geschaltet ist zur Bereitstellung einer dem Ausgangsstrom zugeordneten Spannung.

4. Schaltungsanordnung nach Anspruch 2 oder 3,
   **dadurch gekennzeichnet, dass**
   das Mittel zur Stromerfassung (7) einen Dämpfungskondensator (9) umfasst, der zwischen den Anschluss der gesteuerten Strecke des Ausgangstransistors (6) und einen Bezugspotentialanschluss (4) geschaltet ist, ausgelegt zum zuverlässigen Detektieren eines Kurzschlusses zwischen einem zweiten Anschluss der gesteuerten Strecke des Ausgangstransistors (6) und einem Versorgungspotentialanschluss (13).

5. Schaltungsanordnung nach Anspruch 4,
   **dadurch gekennzeichnet, dass**
   zwischen den zweiten Anschluss der gesteuerten Strecke des Ausgangstransistors (6) und einen Bezugspotentialanschluss (4) ein Entstörkondensator (15) ausgelegt zur Unterdrückung hochfrequenter Störungen geschaltet ist.

6. Schaltungsanordnung nach einem der Ansprüche 1 bis 5,
   **dadurch gekennzeichnet, dass**
   die Referenzquelle einen Spannungsteiler (11, 12) umfasst, mit einem Ausgangsknoten, der mit dem zweiten Eingang des Vergleichers (10, 14) verbunden ist.

7. Schaltungsanordnung nach einem der Ansprüche 1 bis 6,
   **dadurch gekennzeichnet, dass**
   das Kippglied (3) ein Flip-Flop ist.

8. Schaltungsanordnung nach einem der Ansprüche 1 bis 7,
   **dadurch gekennzeichnet, dass**
   der Frequenzteiler (16) ausgebildet ist zum Bereitstellen eines Signals mit geteilter Frequenz des Eingangssignals, welches der halben Frequenz des Eingangssignals entspricht.

9. Schaltungsanordnung nach einem der Ansprüche 1 bis 8,
   **dadurch gekennzeichnet, dass**
   der Takteingang (CLK) des Kippgliedes (3) an eine Impulsquelle (25) angeschlossen ist, die wegabhängige Impulse abgibt.

## FIG 1

## FIG 2

## FIG 3

## FIG 4

# FIG 5

**Europäisches Patentamt**

**EUROPÄISCHER RECHERCHENBERICHT**

Nummer der Anmeldung

EP 03 00 9627

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 4 562 387 A (LEHNHOFF RICHARD N) 31. Dezember 1985 (1985-12-31) * Spalte 2, Zeile 40 - Spalte 4, Zeile 29; Abbildung 1 * --- | 1-9 | H03K3/037 H03K17/082 |
| A | US 5 519 341 A (CORSI MARCO ET AL) 21. Mai 1996 (1996-05-21) * Abbildung 3 * ----- | | |

RECHERCHIERTE SACHGEBIETE (Int.Cl.7)

H03K

Der vorliegende Recherchenbericht wurde für alle Patentansprüche erstellt

| Recherchenort | Abschlußdatum der Recherche | Prüfer |
|---|---|---|
| MÜNCHEN | 19. August 2003 | Moll, P |

**ANHANG ZUM EUROPÄISCHEN RECHERCHENBERICHT
ÜBER DIE EUROPÄISCHE PATENTANMELDUNG NR.**

EP 03 00 9627

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-08-2003

| Im Recherchenbericht angeführtes Patentdokument | Datum der Veröffentlichung | Mitglied(er) der Patentfamilie | Datum der Veröffentlichung |
|---|---|---|---|
| US 4562387 A | 31-12-1985 | CA 1222306 A1<br>EP 0185449 A1<br>JP 61137984 A | 26-05-1987<br>25-06-1986<br>25-06-1986 |
| US 5519341 A | 21-05-1996 | KEINE | |

EPO FORM P0461

Für nähere Einzelheiten zu diesem Anhang : siehe Amtsblatt des Europäischen Patentamts, Nr.12/82